# EUROPÄISCHE PATENTSCHRIFT

(11) **EP 0 524 601 B1**
(45) Veröffentlichungstag und Bekanntmachung des Hinweises auf die Patenterteilung: **04.06.1997**
(21) Anmeldenummer: 92112438.4
(22) Anmeldetag: 21.07.1992
(51) Int. Cl.: H04B 10/00, H03K 17/785

(54) **Optokoppler**
Photocoupleur
Optocoupleur

(30) Priorität: 23.07.1991 DE 4124400
(43) Veröffentlichungstag der Anmeldung: 27.01.1993
(73) Patentinhaber: SIEMENS AKTIENGESELLSCHAFT, 80333 München (DE)
(72) Erfinder: Kaifler, Erich, Dipl.-Ing. (FH), W-8028 Taufkirchen (DE)

(56) Entgegenhaltungen:
- US-A- 4 603 234
- US-A- 4 682 061
- JOURNAL OF LIGHTWAVE TECHNOLOGY. Bd. LT-5, Nr. 10, Oktober 1987, NEW YORK US Seiten 1382 - 1390 HIDEAKI MATSUEDA 'AlGaAs OEIC Transmitters'

## Beschreibung

Die Erfindung bezieht sich auf einen Optokoppler mit einer Lichtquelle und einem Lichtempfänger.

Solche Optokoppler sind Stand der Technik. Die Lichtquelle besteht im allgemeinen aus einer lichtemittierenden Diode (LED), der Lichtempfänger aus einer lichtempfindlichen Diode oder einem Fototransistor. Wegen des geringen Stromübertragungsverhältnisses I_{C}/I_{F} (I_{C} = Kollektorstrom, I_{F} = Fotostrom) ist der auf der Empfängerseite fließende Strom niedrig. Er beträgt bei handelsüblichen Optokopplern z. B. 100 mA. Die maximale Spannung am Empfängerkreis liegt meistens unter 100 V.

US-A-4 682 061 zeigt einen Schaltkreis bei dem ein Optokoppler in Verbindung mit einer Stromquelle zwei Schalt-MOSFET's schaltet.

Ziel der Erfindung ist, einen Optokoppler derart weiterzubilden, daß er im Empfängerkreis einen wesentlich größeren Strom bei gleichzeitig höherer Spannung zuläßt.

Dieses Ziel wird dadurch erreicht, daß dem Lichtempfänger eine Stromquelle in Reihe geschaltet ist, daß der Knoten zwischen dem Lichtempfänger und der Stromquelle mit dem Gateanschluß eines Vertikal-MOSFET verbunden ist und das dessen Source- und Drainanschluß mit je einem Ausgangsanschluß verbunden sind.

Weiterbildungen der Erfindung sind Gegenstand der abhängigen Ansprüche.

Die Erfindung wird anhand zweier Ausführungsbeispiele in Verbindung mit den Figuren näher erläutert. Es zeigen:
- Figur 1: ein erstes Ausführungsbeispiel eines Optokopplers
- Figur 2: ein zweites Ausführungsbeispiel und
- Figur 3: eine integrierte Ausführung der Schaltungsanordnung nach Figur 1.

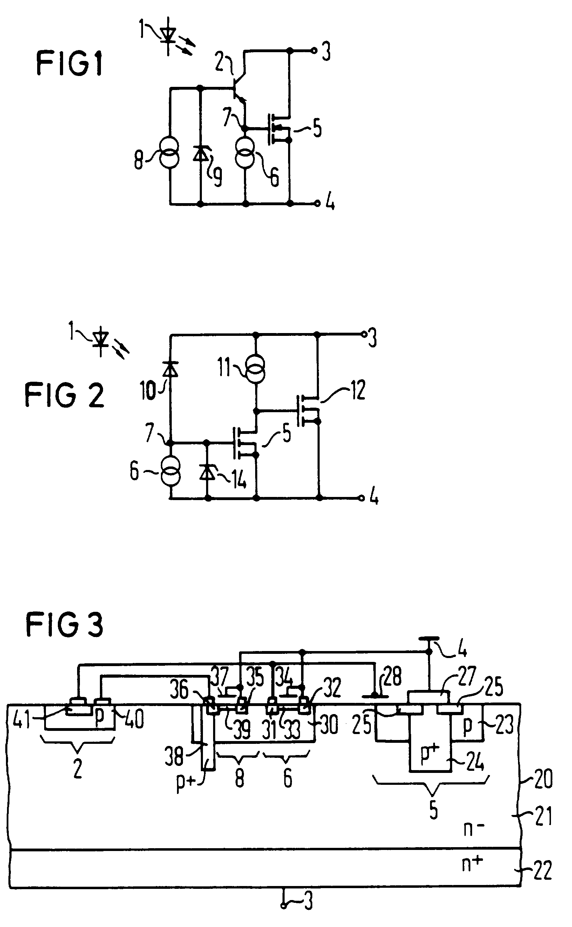

Der Optokoppler nach Figur 1 enthält eine LED 1 und einen Fototransistor 2. Dem Fototransistor ist emitterseitig eine Stromquelle 6 in Reihe geschaltet. Die Reihenschaltung aus Fototransistor und Stromquelle liegt an Ausgangsanschlüssen 3, 4. Zwischen die Ausgangsanschlüsse 3, 4 ist ein Vertikal-MOSFET 5 geschaltet, dessen Gateanschluß mit dem Knoten 7 zwischen Fototransistor 2 und Stromquelle 6 verbunden ist. Der Sourceanschluß des Vertikal-MOSFET 5 liegt am Anschluß 4, sein Drainanschluß am Anschluß 3.

Die Stromquelle 6 ist derart dimensioniert, daß der bei unbeleuchtetem Fototransistor 2 fließende Sperrstrom mindestens zum größten Teil durch die Stromquelle 6 abfließt. Der in die Gate-Sourcekapazität des MOSFET 5 fließende Strom ist so klein, daß er nicht ausreicht, um den MOSFET 5 einzuschalten. Sendet die LED 1 Licht aus, so wird der Fototransistor 2 leitend gesteuert. Der Fotostrom ist nun größer als der eingeprägte Strom der Stromquelle 6. Damit wird die Gate-Source-Kapazität des MOSFET 5 aufgeladen und der MOSFET wird leitend gesteuert. Damit wird eine vorzugsweise am Anschluß 3 angeschlossene Last vom Strom durchflossen.

Um den Arbeitspunkt des Fototransistors 2 genau einzustellen, kann zwischen seinem Emitteranschluß und den Ausgangsanschluß 4 eine weitere Stromquelle 8 geschaltet werden. Ihr Strom ist derart bemessen, daß der Fototransistor 2 im unbeleuchteten Zustand sicher gesperrt bleibt. Zum Schutz des Basis-Emitter-pn-Übergangs des Fototransistors 2 kann der Stromquelle 8 eine Zenerdiode 9 parallelgeschaltet werden.

Der MOSFET 5 ist, wie erwähnt, ein Vertikal-MOSFET, der in vielen Ausführungen bis zu einigen 100 Volt Sperrspannungen auf dem Markt ist. Mit einem solchen MOSFET ist es auch möglich, einen hohen Strom zu schalten.

In Figur 2 ist ein Optokoppler dargestellt, der im unbeleuchteten Zustand Strom führt und im beleuchteten Zustand sperrt. Solche Typen von Optokopplern sind z. B. in der Regelungstechnik und bei kontaktlosen Relais verwendbar, die normalerweise leitend sind und daher einem mechanischen Relais mit Ruhekontakt ähneln.

Der Lichtempfänger besteht hier aus einer Fotodiode 10, dem die Stromquelle 6 in Reihe geschaltet ist. Der Knoten zwischen der Anodenseite der Fotodiode 10 und der Stromquelle 6 ist mit dem Gateanschluß des Vertikal-MOSFET 5 verbunden. In Reihe mit dem MOSFET 5 ist eine weitere Stromquelle 11 geschaltet. Die Reihenschaltung aus weiterer Stromquelle 11 und MOSFET 5 ist der Reihenschaltung aus Fotodiode 10 und Stromquelle 6 parallel geschaltet und liegt an den Ausgangsanschlüssen 3, 4. Der Drainanschluß des MOSFET 5 ist mit dem Gateanschluß eines Vertikal-MOSFET 12 verbunden, dessen Drainanschluß mit dem Ausgangsanschluß 3 und dessen Sourceanschluß mit dem Ausgangsanschluß verbunden ist. Zum Schutz der Gate-Source-Strecke des MOSFET 5 kann dieser eine Zenerdiode 14 parallel geschaltet sein.

Im unbeleuchteten Zustand des Optokopplers nach Figur 2 ist der MOSFET 5 gesperrt. Vom Ausgangsanschluß 3 fließt über die weitere Stromquelle 11 ein Strom in die Gate-Source-Kapazität des MOSFET 12. Dieser Strom ist so bemessen, daß der MOSFET 12 leitet. Wird der Optokoppler beleuchtet, so fließt durch die Fotodiode 10 ein erhöhter Sperrstrom, die den MOSFET 5 leitend steuert. Damit fließt der Steuerstrom für den MOSFET 12 durch die weitere Stromquelle 11 und durch den MOSFET 5 zum Ausgangsanschluß 4 ab und der MOSFET 12 wird gesperrt.

Eine integrierte Anordnung der Schaltung nach Figur 1 ist in Figur 3 dargestellt. Sie ist in einem Halbleiterkörper 20 aufgebaut, der eine erste, schwach dotierte Zone 21 enthält. Diese liegt auf einem stark n-dotierten Substrat 22. Der Vertikal-MOSFET 5 enthält eine p-dotierte Gatezone 23, die planar in der Zone 21 eingebettet ist. Ein zentraler tieferer Teil der Gatezone 23 ist mit 24 bezeichnet und ist stark dotiert. In die Zone 23, 24 ist eine stark n-dotierte Sourcezone 25 eingebettet. Sourcezone 25 und Gatezone 23, 24 sind von einer Sourceelektrode 27 kontaktiert. Über der Gatezone 23 ist, elektrisch von dieser isoliert, eine Gateelektrode 28 angebracht. Diese überlappt auf der einen Seite die Sourcezone 25 und auf der anderen Seite die Zone 21.

Die genannten Zonen bilden zusammen mit der Zone 21 den Vertikal-MOSFET 5. Seine Drainzone ist die Zone 21.

Die Stromquellen 6, 8 sind durch zwei Lateral-MOSFET vom Depletion-Typ gebildet, deren Sourcezonen elektrisch jeweils mit ihrer Gateelektrode verbunden sind. Die MOSFET sitzen in einer schwach p-dotierten Wanne 30 und haben stark dotierte Sourcezonen 32 bzw. 35 und stark n-dotierte Drainzonen 31 bzw. 36. Zwischen den Source- und Drainzonen liegen schwach n-dotierte Kanalzonen 33 bzw. 39. Die Kanalzonen 33, 39 sind durch elektrisch gegen sie isolierte Gateelektroden 34 bzw. 37 überdeckt. Die Gateelektroden 34, 37 überlappen die Source- und Drainzonen 32, 31 bzw. 35, 36.

Die Zenerdiode 9 ist durch ein stark p-dotiertes Gebiet 38 gebildet, das innerhalb der Wanne 30 angeordnet ist, jedoch eine wesentlich größere Tiefe als diese hat. Die Zone 38 ist die Anodenzone der Zenerdiode, die Zone 21 die Katodenzone.

Der Fototransistor 2 ist durch eine in die Zone 21 eingebettete p-dotierte Basiszone 40 und durch eine stark n-dotierte Emitterzone 41 gebildet, die in der Zone 40 eingebettet ist. Die Kollektorzone ist die Zone 21.

Entsprechend der Schaltungsanordnung nach Figur 1 ist die Emitterzone 41 elektrisch mit der Gateelektrode 28 des MOSFET 5 und die Basiszone 40 mit der Drainzone 36 und mit der Anodenzone 38 der Zenerdiode 9 verbunden. Die Sourcezonen 32, 39 der Stromquellen 6, 8 sind mit der Anschlußklemme 4 verbunden. Das Substrat 22 der integrierten Schaltung liegt am Ausgangsanschluß 3, der Sourceanschluß des FET 5 am Anschluß 4. Die Funktionsweise der integrierten Schaltung nach Figur 3 entspricht der nach Figur 1.

## Patentansprüche

1. Optokoppler mit einer Lichtquelle (1) und einem Lichtempfänger,
**dadurch gekennzeichnet,** daß dem Lichtempfänger (2, 10) eine Stromquelle (6) in Reihe geschaltet ist, daß der Knoten (7) zwischen dem Lichtempfänger und der Stromquelle mit dem Gateanschluß eines Vertikal-MOSFET (5) verbunden ist und daß dessen Source- und Drainanschluß mit je einem Ausgangsanschluß (3, 4) verbunden sind.

2. Optokoppler nach Anspruch 1,
**dadurch gekennzeichnet,** daß der Lichtempfänger ein Fototransistor (2) ist und daß die Stromquelle (6) mit dem Emitteranschluß des Fototransistors (8) verbunden ist.

3. Optokoppler nach Anspruch 1 oder 2,
**dadurch gekennzeichnet,** daß zwischen den Basisanschluß des Fototransistors (2) und dem Sourceanschluß des Vertikal-MOSFET (5) eine weitere Stromquelle (8) geschaltet ist.

4. Optokoppler nach Anspruch 3,
**dadurch gekennzeichnet,** daß der weiteren Stromquelle (8) eine Zenerdiode (9) parallel geschaltet ist.

5. Optokoppler nach Anspruch 1,
**dadurch gekennzeichnet,** daß der Lichtempfänger eine Fotodiode (10) ist und daß der Anodenanschluß der Fotodiode mit der Stromquelle (6) verbunden ist.

6. Optokoppler nach Anspruch 1,
**dadurch gekennzeichnet,** daß der Stromquelle (6) eine Zenerdiode (14) parallel geschaltet ist.

7. Optokoppler nach Anspruch 1,
**dadurch gekennzeichnet,** daß der Vertikal-MOSFET (5) vom Enhancement-Typ ist, daß zwischen Sourceanschluß und dem einen Ausgangsanschluß (3) eine weitere Stromquelle (11) angeschlossen ist, daß zwischen den Ausgangsanschlüssen ein weiterer Vertikal-MOSFET (12) vom Enhancement-Typ angeschlossen ist und daß der Gateanschluß des weiteren Vertikal-MOSFET mit dem Drainanschluß des ersten Vertikal-MOSFET (5) verbunden ist.

8. Optokoppler nach einem der Ansprüche 1 bis 7,
**dadurch gekennzeichnet,** daß alle Komponenten des Lichtempfängers in einem einzigen Chip integriert sind.

## Claims

1. Optocoupler having a light source (1) and a light receiver, characterized in that a current source (6) is connected in series with the light receiver (2, 10), in that the junction (7) between the light receiver and the current source is connected to the gate terminal of a vertical MOSFET (5), and in that its source and drain terminal are each connected to an output terminal (3, 4).

2. Optocoupler according to Claim 1, characterized in that the light receiver is a phototransistor (2), and in that the current source (6) is connected to the emitter terminal of the phototransistor (2).

3. Optocoupler according to Claim 1 or 2, characterized in that a further current source (8) is connected between the base terminal of the phototransistor (2) and the source terminal of the vertical MOSFET (5).

4. Optocoupler according to Claim 3, characterized in that a Zener diode (9) is connected in parallel with the further current source (8).

5. Optocoupler according to Claim 1, characterized in that the light receiver is a photodiode (10), and in that the anode terminal of the photodiode is connected to the current source (6).

6. Optocoupler according to Claim 1, characterized in that a Zener diode (14) is connected in parallel with the current source (6).

7. Optocoupler according to Claim 1, characterized in that the vertical MOSFET (5) is of the enhancement type, in that a further current source (11) is connected between the source terminal and one output terminal (3), in that a further vertical MOSFET (12) of the enhancement type is connected between the output terminals, and in that the gate terminal of the further vertical MOSFET is connected to the drain terminal of the first vertical MOSFET (5).

8. Optocoupler according to one of Claims 1 to 7, characterized in that all the components of the light receiver are integrated in a single chip.

## Revendications

1. Optocoupleur avec source lumineuse (1) et d'un photodétecteur, caractérisé en ce qu'une source de courant (6) est montée en série avec le photodétecteur (2, 10), en ce que le noeud (7) situé entre le photodétecteur et la source de courant est relié à la borne de grille d'un MOSFET à structure verticale (5) et en ce que la borne de la source et la borne du drain de ce dernier sont respectivement reliées à une borne de sortie (3, 4).

2. Optocoupleur selon la revendication 1,
caractérisé en ce que le photodétecteur est un phototransistor (2) et en ce que la source de courant (6) est reliée à la borne d'émetteur du phototransistor (8).

3. Optocoupleur selon la revendication 1 ou 2,
caractérisé en ce qu'une autre source de courant (8) est intercalée entre la borne de la base du phototransistor (2) et la borne de la source du MOSFET à structure verticale (5).

4. Optocoupleur selon la revendication 3,
caractérisé en ce qu'une diode Zener (9) est montée parallèlement à l'autre source de courant (8).

5. Optocoupleur selon la revendication 1,
caractérisé en ce que le photodétecteur est une photodiode (10) et en ce que la borne anodique de la photodiode est reliée à la source de courant (6).

6. Optocoupleur selon la revendication 1,
caractérisé en ce qu'une diode Zener (14) est montée parallèlement à la source de courant (6).

7. Optocoupleur selon la revendication 1,
caractérisé en ce que le MOSFET à structure verticale (5) est du type à enrichissement, en ce qu'une autre source de courant (11) est raccordée entre la borne de source et une borne de sortie (3), en ce qu'un autre MOSFET à structure verticale (12) du type à enrichissement est raccordé entre les bornes de sortie et en ce que la borne de grille de l'autre MOSFET à structure verticale est reliée à la borne de drain du premier MOSFET à structure verticale (5).

8. Optocoupleur selon l'une des revendications 1 à 7,
caractérisé en ce que tous les composants du photodétecteur sont intégrés dans une puce unique.
